# EUROPEAN PATENT APPLICATION

(11) **EP 4 383 979 A1**
(43) Date of publication of application: **12.06.2024**
(21) Application number: 23214005.3
(22) Date of filing: 04.12.2023
(51) Int. Cl.: H10B 12/00, H01L 27/12

(54) **INTEGRATED CIRCUIT DEVICE AND METHOD OF MANUFACTURING THE SAME**

(30) Priority: 06.12.2022 KR 20220169098
(71) Applicant: Samsung Electronics Co., Ltd., Suwon-si, Gyeonggi-do 16677 (KR)
(72) Inventor: KIM, Gangjun, 16677 Suwon-si, Gyeonggi-do (KR)
(74) Representative: Kuhnen & Wacker Patent- und Rechtsanwaltsbüro PartG mbB

(57) **Abstract**

An integrated circuit device includes a substrate including an element isolation film defining an active area, and a gate structure buried in the active area of the substrate. The gate structure includes a gate trench, an outer insulating layer conformed along an inner wall of the gate trench, a channel structure layer conformed on the outer insulating layer, a gate insulating layer conformed on the channel structure layer, a gate electrode layer filling a lower area of the gate trench, and a capping insulating layer on the gate electrode layer, the capping insulating layer filling an upper area of the gate trench.

## Description

### FIELD

Some example embodiments of the inventive concepts relate to an integrated circuit device and/or a manufacturing method thereof, including an integrated circuit device including a buried word line and/or a manufacturing method thereof.

### BACKGROUND

Recently, as the degree of integration of integrated circuit devices has gradually increased, a structure of an integrated circuit device having a buried channel array transistor (BCAT) in which a plurality of word lines are buried in a substrate has been proposed. Accordingly, various studies are being conducted to improve and stabilize the operation and reliability of the BCAT. In particular, as design rules of integrated circuit devices rapidly decrease, line widths of buried word lines also rapidly decrease.

### SUMMARY

Some example embodiments of the inventive concepts provide an integrated circuit device having high integration and high reliability by forming an independent channel structure layer made of a semiconductor material on each of buried word lines.

Some example embodiments inventive concepts provide a method of manufacturing an integrated circuit device having high integration and high reliability by forming an independent channel structure layer made of a semiconductor material on each of buried word lines.

Example problems to be solved by example embodiments of the inventive concepts are not limited to the problems mentioned above, and other problems not mentioned will be clearly understood by those skilled in the art from the following description.

According to some example embodiments of the inventive concepts, an integrated circuit device includes a substrate including an element isolation film defining an active area, and a gate structure buried in the active area of the substrate. The gate structure includes a gate trench, an outer insulating layer conformed along an inner wall of the gate trench, a channel structure layer conformed on the outer insulating layer, a gate insulating layer conformed on the channel structure layer, a gate electrode layer filling a lower area of the gate trench, and a capping insulating layer on the gate electrode layer, the capping insulating layer filling an upper area of the gate trench.

According to some example embodiments of the inventive concepts, an integrated circuit device includes a substrate, a peripheral circuit structure on the substrate, the peripheral circuit structure including a peripheral circuit, a memory cell structure on the peripheral circuit structure, the memory cell structure including an element isolation film defining an active area, and a plurality of gate structures buried in the active area of the memory cell structure. Each of the plurality of gate structures includes a gate trench, an outer insulating layer conformed along an inner wall of the gate trench, a channel structure layer conformed on the outer insulating layer, a gate insulating layer conformed on the channel structure layer, a gate electrode layer filling a lower area of the gate trench, and a capping insulating layer on the gate electrode layer, the capping insulating layer filling an upper area of the gate trench, and at least a portion of the plurality of gate structures electrically connected to the peripheral circuit through a vertical via.

According to some example embodiments of the inventive concepts, an integrated circuit device includes a first structure, and a second structure stacked on the first structure. The first structure includes a first substrate, a peripheral circuit on the first substrate, a first insulating layer configured to cover the first substrate and the peripheral circuit, and a first bonding pad on the first insulating layer and electrically connected to the peripheral circuit. The second structure includes a second substrate facing the first substrate, a plurality of gate structures buried in an active area of the second substrate, a second insulating layer covering the second substrate and the gate structure, and a second bonding pad on the second insulating layer and electrically connected to the gate structure. Each of the plurality of gate structures includes a gate trench, an outer insulating layer conformed along an inner wall of the gate trench, a channel structure layer conformed on the outer insulating layer, a gate insulating layer conformed on the channel structure layer, a gate electrode layer filling a lower area of the gate trench, and a capping insulating layer on the gate electrode layer, the capping insulating layer filling an upper area of the gate trench, and the first bonding pad and the second bonding pad bonded to each other.

### BRIEF DESCRIPTION OF THE DRAWINGS

Some example embodiments will be more clearly understood from the following detailed description taken in conjunction with the accompanying drawings in which:
FIG. 1 is a layout diagram showing an integrated circuit device according to an example embodiment of the inventive concepts;
FIG. 2 is a cross-sectional view taken along lines A-A' and B-B' of FIG. 1;
FIG. 3 is an enlarged view of a portion CX1 of FIG. 2;
FIG. 4 is an enlarged cross-sectional view showing an integrated circuit device according to another example embodiment of the inventive concepts;
FIGS. 5 to 7 are cross-sectional views showing an integrated circuit device according to another example embodiment of the inventive concepts;
FIG. 8 is a flowchart illustrating a method of manufacturing an integrated circuit device, according to an example embodiment of the inventive concepts;
FIGS. 9 to 25 are cross-sectional views showing a manufacturing method of an integrated circuit device, according to an example embodiment of the inventive concepts according to a process sequence; and
FIG. 26 is a configuration diagram illustrating a system including an integrated circuit device according to an example embodiment of the inventive concepts.

### DETAILED DESCRIPTION

Hereinafter, some example embodiments of the inventive concepts will be described in detail with reference to the accompanying drawings.

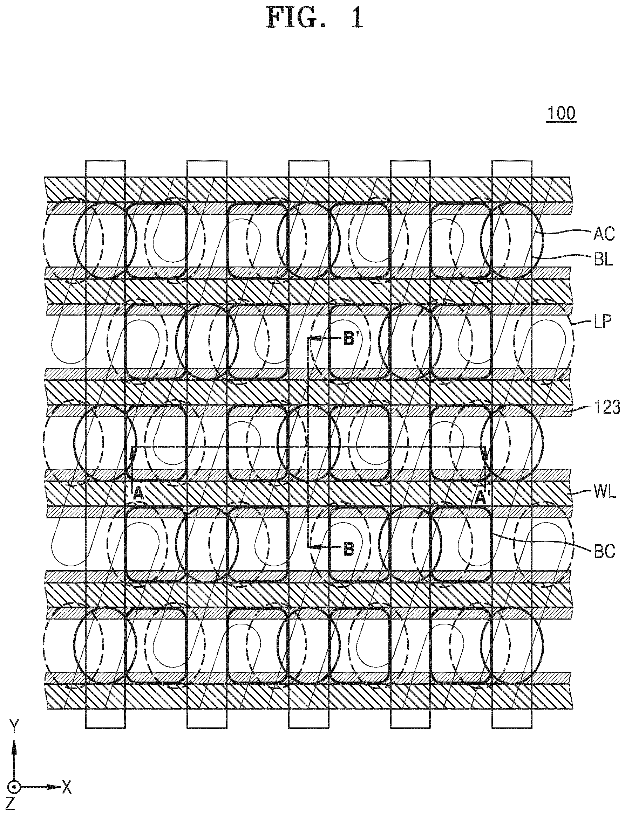

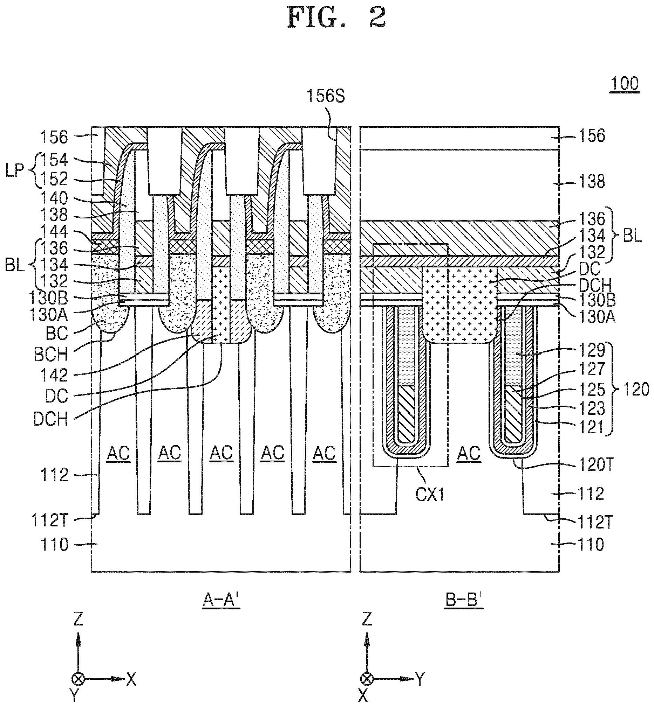

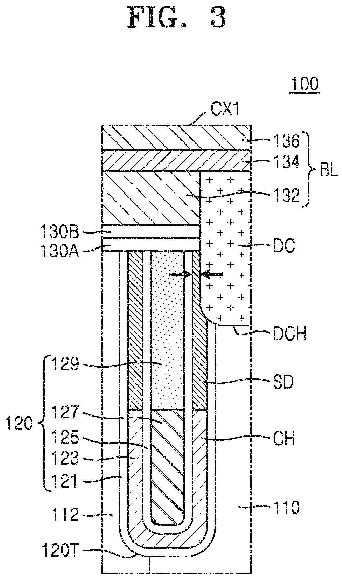

FIG. 1 is a layout diagram illustrating an integrated circuit device according to an example embodiment of the inventive concepts, FIG. 2 is a cross-sectional view taken along lines A-A' and B-B' of FIG. 1, and FIG. 3 is an enlarged view of a portion CX1 of FIG. 2.

Referring to FIGS. 1 to 3, an integrated circuit device 100 includes a substrate 110 having an element isolation film 112 defining an active area AC and a gate structure 120 buried in the active area AC of the substrate 110.

The substrate 110 may have an active area AC defined by the element isolation film 112. The substrate 110 may be a wafer including silicon (Si). In some example embodiments, the substrate 110 may be a wafer including a semiconductor element, such as germanium (Ge), or a compound semiconductor, such as silicon carbide (SiC), gallium arsenide (GaAs), indium arsenide (InAs), or indium phosphide (InP), but example embodiments are not limited thereto. Meanwhile, the substrate 110 may have a silicon on insulator (SOI) structure. In addition, the substrate 110 may include a conductive region, for example, a well doped with an impurity or a structure doped with an impurity.

The element isolation film 112 may have, for example, a shallow trench isolation (STI) structure. The element isolation film 112 may include an insulating material filling the element isolation trench 112T formed in the substrate 110. For example, the insulating material may include fluoride silicate glass (FSG), undoped silicate glass (USG), boro-phospho-silicate glass (BPSG), phospho-silicate glass (PSG), flowable oxide (FOX), plasma enhanced tetra-ethyl-ortho-silicate (PE-TEOS), and tonen silazene (TOSZ), but example embodiments are not limited thereto.

The plurality of active areas AC may be arranged to have long axes in an oblique direction with respect to the first horizontal direction (e.g., an X direction) and the second horizontal direction (e.g., a Y direction), respectively. A plurality of word lines WL may extend parallel to each other in the first horizontal direction (X direction) across the plurality of active areas AC.

A plurality of bit lines BL may extend parallel or substantially parallel to each other in the second horizontal direction (Y direction) on the plurality of word lines WL. The bit line BL may be connected to the active area AC through a direct contact DC.

A plurality of buried contacts BC may be formed between adjacent bit lines BL among the plurality of bit lines BL. The plurality of buried contacts BC may be arranged in a line in the first horizontal direction (X direction) and the second horizontal direction (Y direction).

A plurality of landing pads LP may be formed on the plurality of buried contacts BC. The plurality of buried contacts BC and the plurality of landing pads LP may connect capacitors (not shown) formed on the plurality of bit lines BL to the active area AC. Each of the plurality of landing pads LP may be disposed to partially overlap the buried contact BC.

The substrate 110 may include a gate trench 120T extending in the first horizontal direction (X direction). The gate trench 120T intersects with the active area AC and may be formed to a desired (or alternatively, preset) depth from the upper surface of the substrate 110. A portion of the gate trench 120T may extend into the element isolation film 112, and the gate trench 120T formed in the element isolation film 112 may have a bottom surface at a lower level than the gate trench 120T formed in the active area AC.

A gate structure 120 may be formed inside the gate trench 120T. The gate structure 120 may include an outer insulating layer 121 conformally formed along an inner wall of the gate trench 120T, a channel structure layer 123 conformally formed on the outer insulating layer 121, a gate insulating layer 125 conformally formed on the channel structure layer 123, a gate electrode layer 127 filling the lower region of the gate trench 120T, and a capping insulating layer 129 formed on the gate electrode layer 127 and filling an upper region of the gate trench 120T. The gate structure 120 may correspond to the word line WL. That is, the gate structure 120 may mean the same as the buried word line WL.

The outer insulating layer 121 may be conformally formed on the inner wall of the gate trench 120T to a desired (or alternatively, preset) thickness. The outer insulating layer 121 may be formed of at least one selected from silicon oxide, silicon nitride, and silicon oxynitride. In some example embodiments, the outer insulating layer 121 may be formed by a chemical vapor deposition (CVD) process or an atomic layer deposition (ALD) process. In other example embodiments, the outer insulating layer 121 may be formed by an epitaxial growth process.

The channel structure layer 123 may be conformally formed on the inner wall of the outer insulating layer 121 to a desired (or alternatively, preset) thickness. The channel structure layer 123 may be any one selected from polysilicon, crystalline silicon, crystalline indium gallium zinc oxide (IGZO), and amorphous IGZO, but example embodiments are not limited thereto.

The upper area of the channel structure layer 123 is doped with a relatively high concentration to operate as a source/drain region SD, and the lower area of the channel structure layer 123 may be doped with a relatively low concentration to operate as a channel region CH. The upper area (e.g., the source/drain region) of the channel structure layer 123 may be doped with impurities of a different conductivity type from those doped in the lower area (e.g., the channel region) of the channel structure layer 123. In other words, the source/drain region SD may be doped with n-type or p-type impurities at a high concentration, and the channel region CH may be doped with p-type or n-type impurities at a low concentration. Though not shown, the gate electrode layer 127 may be electrically connected to a word line WL, a first end of the channel structure layer 123 may be electrically connected to a bit line BL, and a second end of the channel structure layer 123 may be electrically connected to a capacitor.

The gate insulating layer 125 may be conformally formed on the inner wall of the channel structure layer 123 to a desired (or alternatively, preset) thickness. The gate insulating layer 125 may be formed of at least one selected from a group consisting of silicon oxide, silicon nitride, silicon oxynitride, oxide/nitride/oxide (ONO), and a high-k material having a higher dielectric constant than silicon oxide, but example embodiments are not limited thereto.

The gate electrode layer 127 may be formed on the gate insulating layer 125 to fill the gate trench 120T from the bottom of the gate trench 120T to a desired (or alternatively, preset) height. The gate electrode layer 127 may include a work function control layer (not shown) disposed on the gate insulating layer 125 and a buried metal layer (not shown) filling the bottom of the gate trench 120T on the work function control layer.

The capping insulating layer 129 may fill the remaining portion of the gate trench 120T on the gate electrode layer 127. For example, the capping insulating layer 129 may include at least one of silicon oxide, silicon oxynitride, and silicon nitride.

In the gate structure 120 having such a structure, the channel structure layer 123 may be isolated from the substrate 110. That is, since the outer insulating layer 121 is disposed on the outer wall of the channel structure layer 123 and the gate insulating layer 125 is disposed on the inner wall of the channel structure layer 123, the gate structure 120 may have substantially the same state as a fully depleted silicon on insulator (FD-SOI). The channel structure layer 123 may facilitate movement of electrons in the gate structure 120.

A first lower insulating layer 130A and a second lower insulating layer 130B may be disposed on the substrate 110 to cover the upper surface of the capping insulating layer 129. In some example embodiments, the first lower insulating layer 130A may include silicon oxide, and the second lower insulating layer 130B may include silicon oxynitride or silicon nitride.

A plurality of direct contacts DC may be formed in a plurality of direct contact holes DCH in the substrate 110. The plurality of direct contacts DC may contact and be connected to the active area AC and the channel structure layer 123 of the gate structure 120. The plurality of direct contacts DC may include doped polysilicon. For example, the plurality of direct contacts DC may include polysilicon containing n-type impurities, such as phosphorus (P), arsenic (As), bismuth (Bi), and antimony (Sb), at a relatively high concentration, but example embodiments are not limited thereto. Here, the direct contact DC may be referred to as a contact plug.

In some example embodiments, the plurality of direct contacts DC may be disposed by penetrating (for example, partially penetrating) the active area AC, the outer insulating layer 121, and the channel structure layer 123 in a vertical direction (e.g., Z direction). In addition, sidewalls of each of the plurality of direct contacts DC may be formed to be in contact with the channel structure layer 123 but spaced apart from the gate insulating layer 125. In other words, the sidewall of each of the plurality of direct contacts DC and the outer wall of the gate insulating layer 125 face each other, but may be spaced apart from each other with the channel structure layer 123 therebetween. According to this shape, a contact area between the direct contact DC and the channel structure layer 123 may be increased, and thus contact resistance may be reduced.

A plurality of bit lines BL may extend in the second horizontal direction (Y direction) on the substrate 110 and the plurality of direct contacts DC. Each of the plurality of bit lines BL may be connected to the active area AC through a direct contact DC. Each of the plurality of bit lines BL may include a lower conductive layer 132, a middle conductive layer 134, and an upper conductive layer 136 sequentially stacked on the substrate 110. The lower conductive layer 132 may include Si, Ge, W, WN, Co, Ni, Al, Mo, Ru, Ti, TiN, Ta, TaN, Cu, or a combination thereof, but example embodiments are not limited thereto. For example, the lower conductive layer 132 may include doped polysilicon. The middle conductive layer 134 and the upper conductive layer 136 may each include TiN, TiSiN, W, tungsten silicide, or a combination thereof, but example embodiments are not limited thereto. In some example embodiments, the middle conductive layer 134 may be made of TiN, TiSiN, or a combination thereof, and the upper conductive layer 136 may include tungsten (W).

Each of the plurality of bit lines BL may be covered with a plurality of bit line capping layers 138. The plurality of bit line capping layers 138 may include silicon nitride. The plurality of bit line capping layers 13 8 may extend in the second horizontal direction (Y direction) on the plurality of bit lines BL.

Bit line spacers 140 may be disposed on both sidewalls of each of the plurality of bit lines BL, and the bit line spacer 140 may extend in the second horizontal direction (Y direction) on both sidewalls of the plurality of bit lines BL. In some example embodiments, the bit line spacer 140 may have a single-layer structure. In other example embodiments, the bit line spacer 140 may have a multi-layered structure. For example, the bit line spacer 140 may include an air spacer structure having an air space surrounded between insulating layers. A direct contact spacer 142 may be disposed below the bit line spacer 140 to partially cover both sidewalls of the direct contact DC while filling the inside of the direct contact hole DCH.

A plurality of buried contacts BC and a plurality of insulation fences (not shown) may be arranged in a row between each of the plurality of bit lines BL in the second horizontal direction (Y direction). The plurality of buried contacts BC may extend along a vertical direction (Z direction) from the buried contact hole BCH formed in the substrate 110. The plurality of insulation fences may be disposed on the capping insulating layer 129 disposed above the plurality of gate trenches 120T, and disposed one by one between each of the plurality of bit lines BL. In the second horizontal direction (Y direction), both sidewalls of each of the plurality of buried contacts BC may be insulated from each other by the plurality of insulation fences. The plurality of insulation fences may include silicon nitride.

A plurality of metal silicide films 144 and a plurality of landing pads LP may be formed on the plurality of buried contacts BC. The metal silicide film 144 and the landing pad LP may be disposed to overlap the buried contact BC in a vertical direction (Z direction). The metal silicide film 144 may be made of cobalt silicide, nickel silicide, or manganese silicide, but example embodiments are not limited thereto. Each of the plurality of landing pads LP may be connected to the buried contact BC through a metal silicide film 144.

The plurality of landing pads LP may cover at least a portion of an upper surface of the bit line capping layer 138 to overlap a portion of the plurality of bit lines BL in a vertical direction (Z direction). Each of the plurality of landing pads LP may include a conductive barrier film 152 and a conductive landing pad layer 154. The conductive barrier film 152 may include Ti, TiN, or a combination thereof. The conductive landing pad layer 154 may include metal, metal nitride, doped polysilicon, or a combination thereof. For example, the conductive landing pad layer 154 may include W. In a plan view, the plurality of landing pads LP may have a plurality of island-shaped pattern shapes.

The plurality of landing pads LP may be electrically insulated from each other by an insulating pattern 156 filling an insulating space around the plurality of landing pads LP. In some example embodiments, the insulating pattern 156 may include silicon nitride, silicon oxynitride, silicon oxide, or a combination thereof.

Recently, as the degree of integration of integrated circuit devices has gradually increased, a structure of an integrated circuit device having a buried channel array transistor (BCAT) in which a plurality of word lines WL are buried in a substrate 110 has been proposed. Accordingly, various studies are being conducted to improve and stabilize the operation and reliability of the BCAT.

As design rules of integrated circuit devices rapidly decrease, the line width of the buried word line WL also rapidly decreases. In addition, as the separation distance between adjacent word lines WL decreases, problems, such as a disturbance phenomenon due to electrical coupling between adjacent word lines WL, may occur. When the line width occupied by the word line WL is further reduced to inhibit or prevent the disturbance phenomenon, the difficulty of a process of forming the word line WL inside the relatively narrow gate trench 120T may significantly increase. Accordingly, when the manufacturing process is not precisely controlled, the plurality of buried channel transistors connected to the word line WL may have difficulty in having uniform electrical characteristics.

To solve this problem, as the integrated circuit device 100 according to an example embodiment of the inventive concepts applies the FD-SOI structure to the gate structure 120, the gate structure 120 may be isolated from the substrate 110. Accordingly, even if the separation distance between neighboring word lines WL is reduced, since movement of electrons or holes may be blocked by the outer insulating layer 121, electrical coupling or disturbance phenomena may be remarkably reduced.

Ultimately, by forming the channel structure layer 123 made of a semiconductor material on each of the buried word lines WL, the integrated circuit device 100 according to an example embodiment of the inventive concept may have high integration, high reliability, and excellent electrical performance.

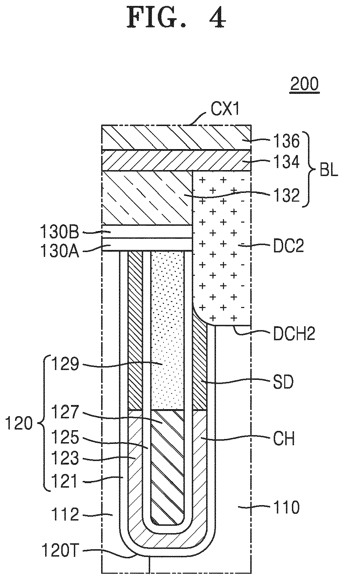

FIG. 4 is an enlarged cross-sectional view illustrating an integrated circuit device according to another example embodiment.

Here, FIG. 4 is an enlarged cross-sectional view corresponding to a portion CX1 of FIG. 2.

Most components constituting an integrated circuit device 200 described below and materials constituting the components are substantially the same as or similar to those described above with reference to FIGS. 1 to 3. Therefore, for convenience of description, the description focuses on the differences from the integrated circuit device 100 described above.

Referring to FIG. 4, the integrated circuit device 200 includes a substrate 110 having an element isolation film 112 defining an active area AC and a gate structure 120 buried in the active area AC of the substrate 110.

A plurality of direct contacts DC2 may be formed in the plurality of direct contact holes DCH2 in the substrate 110. The plurality of direct contacts DC2 may contact and be connected to the active area AC and the channel structure layer 123 of the gate structure 120. The plurality of direct contacts DC2 may include doped polysilicon. For example, the plurality of direct contacts DC2 may include polysilicon containing n-type impurities, such as P, As, Bi, and Sb, at a relatively high concentration, but example embodiments are not limited thereto.

In the integrated circuit device 200 of this example embodiment, the plurality of direct contacts DC2 may be disposed by penetrating (for example, partially penetrating) the active area AC, the outer insulating layer 121, and the channel structure layer 123 in a vertical direction (Z direction). Also, a sidewall of each of the plurality of direct contacts DC2 may be formed to contact an outer wall of the gate insulating layer 125. A rounded bottom of each of the plurality of direct contacts DC2 may be formed to contact the channel structure layer 123. According to this shape, since the direct contact DC2 may be designed to be larger than previous one, resistance may be reduced, and a process margin for contact between the direct contact DC2 and the channel structure layer 123 may be increased.

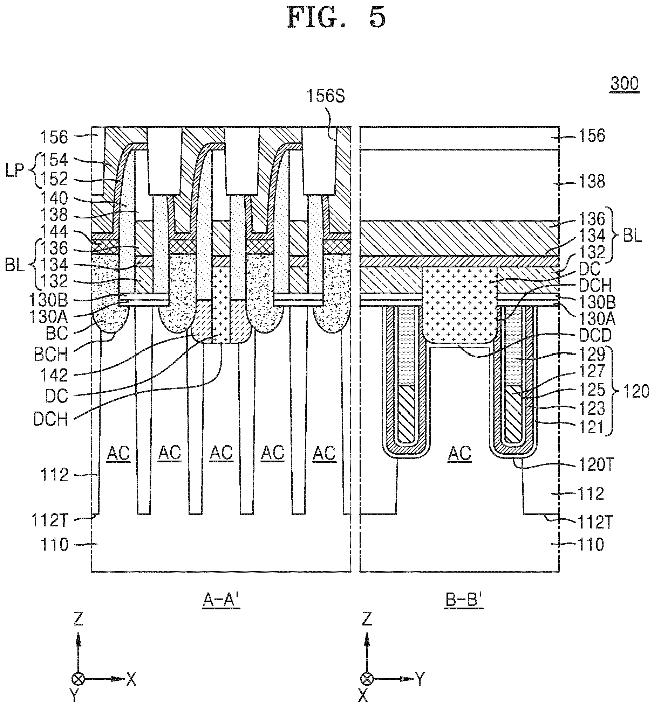

FIGS. 5 to 7 are cross-sectional views showing an integrated circuit device according to another example embodiment of the inventive concepts.

Most components constituting integrated circuit devices 300, 400, and 500 described below and materials constituting the components are substantially the same as or similar to those described above with reference to FIGS. 1 to 3. Therefore, for convenience of description, the description focuses on the differences from the integrated circuit device 100 described above.

Referring to FIG. 5, the integrated circuit device 300 includes a substrate 110 having an element isolation film 112 defining an active area AC and a gate structure 120 buried in the active area AC of the substrate 110.

In the integrated circuit device 300 of this example embodiment, a plurality of direct contacts DC may be formed in the plurality of direct contact holes DCH in the substrate 110. In addition, a contact insulation layer DCD may be formed below the bottom of each of the plurality of direct contacts DC. The contact insulating layer DCD may be between each of the plurality of direct contacts DC and the substrate 110. The contact insulating layer DCD may be continuously connected to the outer insulating layer 121. Accordingly, the plurality of direct contacts DC may contact and be connected only to the channel structure layer 123 of the gate structure 120 without directly contacting the active area AC. The plurality of direct contacts DC may include doped polysilicon. For example, the plurality of direct contacts DC may include polysilicon containing n-type impurities, such as P, As, Bi, and Sb, at a relatively high concentration.

In the integrated circuit device 300 of this example embodiment, the plurality of direct contacts DC may be disposed by penetrating (for example, partially penetrating) the active area AC, the outer insulating layer 121, and the channel structure layer 123 in a vertical direction (Z direction), and the plurality of direct contacts DC may be isolated from the substrate 110 due to the contact insulation layer DCD. According to this shape, leakage current between the direct contact DC and the substrate 110 may be inhibited or prevented.

In addition, since the contact insulation layer DCD is not disposed on the sidewall of each of the plurality of direct contacts DC, sidewalls of each of the plurality of direct contacts DC may contact the channel structure layer 123 and be spaced apart from the gate insulating layer 125. In other words, the sidewall of each of the plurality of direct contacts DC and the outer wall of the gate insulating layer 125 face each other, but may be spaced apart from each other with the channel structure layer 123 therebetween. According to this shape, a contact area between the direct contact DC and the channel structure layer 123 may be increased, and thus contact resistance may be reduced.

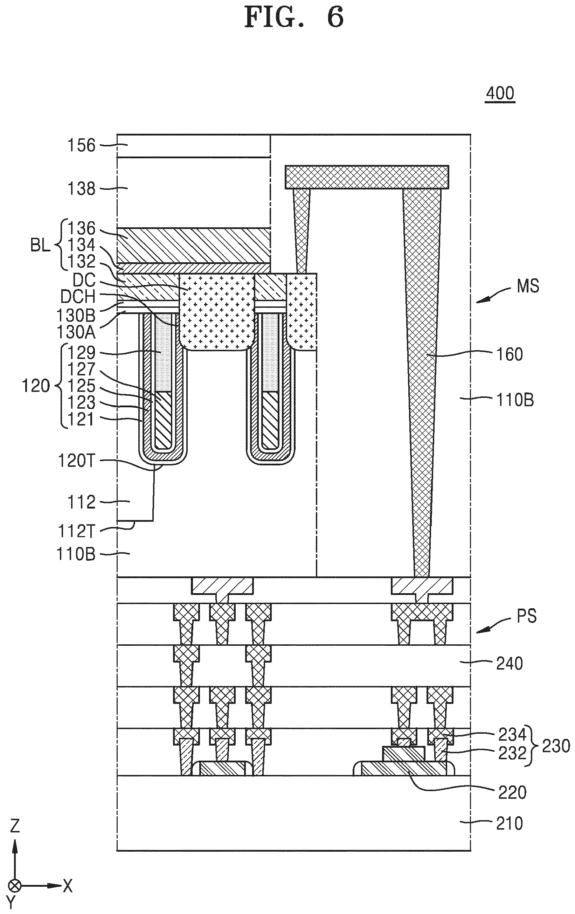

Referring to FIG. 6, the integrated circuit device 400 may include a peripheral circuit structure PS and a memory cell structure MS disposed at a higher vertical level than the peripheral circuit structure PS.

The integrated circuit device 400 of this example embodiment may have a Cell On Periphery (COP) structure in which the memory cell structure MS is disposed on the peripheral circuit structure PS. A body portion 110B of the memory cell structure MS may be disposed on the peripheral circuit structure PS, and a plurality of element isolation films 112 and a plurality of gate structures 120 may be formed in the body portion 110B. The plurality of element isolation films 112 may define active areas in the body portion 110B. The plurality of gate structures 120 may be buried in the active areas of the memory cell structure MS. In some example embodiments, the body portion 110B of the memory cell structure MS may be made of an insulating material including silicon. For example, the body portion 110B may be formed of at least one selected from a group consisting of single crystal silicon, silicon oxide, silicon nitride, and silicon oxynitride.

The peripheral circuit structure PS may include a peripheral circuit. The peripheral circuit may include a peripheral circuit transistor 220 and a peripheral circuit wire 230 disposed on a substrate 210. The peripheral circuit transistor 220 may include a peripheral circuit gate and a source/drain region (not shown) disposed on a portion of the substrate 210 on both sides of the peripheral circuit gate.

The peripheral circuit wire 230 includes a plurality of peripheral circuit contacts 232 and a plurality of peripheral circuit metal layers 234. An interlayer insulating film 240 covering the peripheral circuit transistor 220 and the peripheral circuit wire 230 may be disposed on the substrate 210. The plurality of peripheral circuit metal layers 234 may have a multilayer structure including a plurality of metal layers disposed at different vertical levels. Although the drawings show that the plurality of peripheral circuit metal layers 234 are all formed at the same or substantially the same height, unlike this, the peripheral circuit metal layer 234 disposed on some levels (e.g., disposed on the top level) may be formed to a greater height than the peripheral circuit metal layer 234 disposed on other levels.

Some of the plurality of gate structures 120 of the memory cell structure MS may be electrically connected to the peripheral circuit transistors 220 of the peripheral circuit structure PS through vertical vias 160.

A plurality of direct contacts DC may be formed in a plurality of direct contact holes DCH formed in the body portion 110B of the memory cell structure MS. The plurality of direct contacts DC may contact and be connected to the body portion 110B and the channel structure layer 123 of the gate structure 120. Some of the plurality of direct contacts DC may be electrically connected to the vertical via 160.

Although not shown, in some example embodiments, at least one sidewall of the plurality of direct contacts DC may be disposed to contact the sidewall of the gate insulating layer 125. In other example embodiments, the contact insulation layer DCD (e.g., see FIG. 5) may be disposed between the plurality of direct contacts DC and the body portion 110B of the memory cell structure MS.

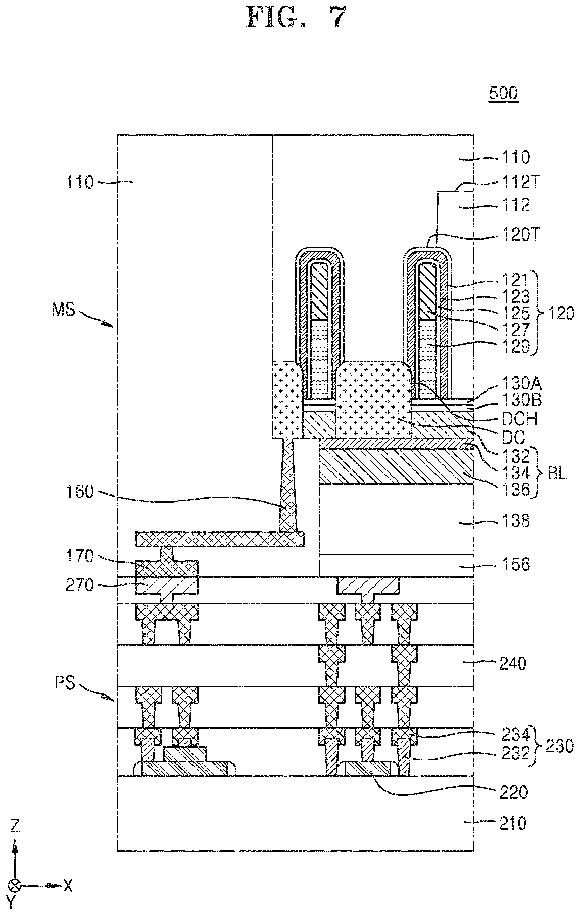

Referring to FIG. 7, the integrated circuit device 500 may include a chip to chip structure configured by a bonding method.

After fabricating the upper substrate including the memory cell structure MS and fabricating the lower substrate including the peripheral circuit structure PS, the integrated circuit device 500 of this example embodiment includes a chip-to-chip structure in which an upper substrate and a lower substrate are connected to each other by a bonding method.

In some example embodiments, the bonding method may refer to a method in which the upper bonding pad 170 formed on the top of the upper chip and the lower bonding pad 270 formed on the top of the lower chip contact each other. The bonding method may include a metal-metal bonding structure, a through silicon via (TSV) structure, a eutectic bonding structure, a plurality of wire line structures, or a combination thereof, but example embodiments are not limited thereto.

Here, the lower substrate may be referred to as a first substrate and the lower bonding pad may be referred to as a first bonding pad. The peripheral circuit structure PS may include a peripheral circuit on the first substrate. A first insulating layer may cover the first substrate and the peripheral circuit. The first bonding pads may be on the first insulating layer and electrically connected to the peripheral circuit. The first substrate and elements formed thereon may be referred to as a first structure. Also, the upper substrate may be referred to as a second substrate and the upper bonding pad may be referred to as a second bonding pad. The memory cell structure MS may include a plurality of gate structures buried in an active area of the second substrate. A second insulating layer may cover the second substrate and the plurality of gate structures. The second bonding pads may be on the second insulating layer and electrically connected to at least one of the plurality of gate structures. The second substrate and elements formed thereon may be referred to as a second structure. In addition, although a capacitor may be disposed between the first substrate and the second substrate, illustration is omitted for convenience of understanding.

Since the description of the peripheral circuit structure PS is substantially the same as described above, a detailed description thereof is omitted. However, in the integrated circuit device 500 of this example embodiment, the peripheral circuit structure PS may further include a lower bonding pad 270 electrically connected to the peripheral circuit transistor 220 on the interlayer insulating film 240.

Some of the plurality of gate structures 120 of the memory cell structure MS may be electrically connected to the peripheral circuit transistor 220 of the peripheral circuit structure PS through the vertical via 160 and the upper bonding pad 170.

A plurality of direct contacts DC may be formed in the plurality of direct contact holes DCH formed in the substrate 110 of the memory cell structure MS. The plurality of direct contacts DC may contact and be connected to the substrate 110 and the channel structure layer 123 of the gate structure 120. Some of the plurality of direct contacts DC may be electrically connected to the vertical via 160.

Although not shown, in some example embodiments, at least one sidewall of the plurality of direct contacts DC may be disposed to contact the sidewall of the gate insulating layer 125. In other example embodiments, a contact insulation layer DCD (e.g., see FIG. 5) may be disposed between the plurality of direct contacts DC and the substrate 110 of the memory cell structure MS.

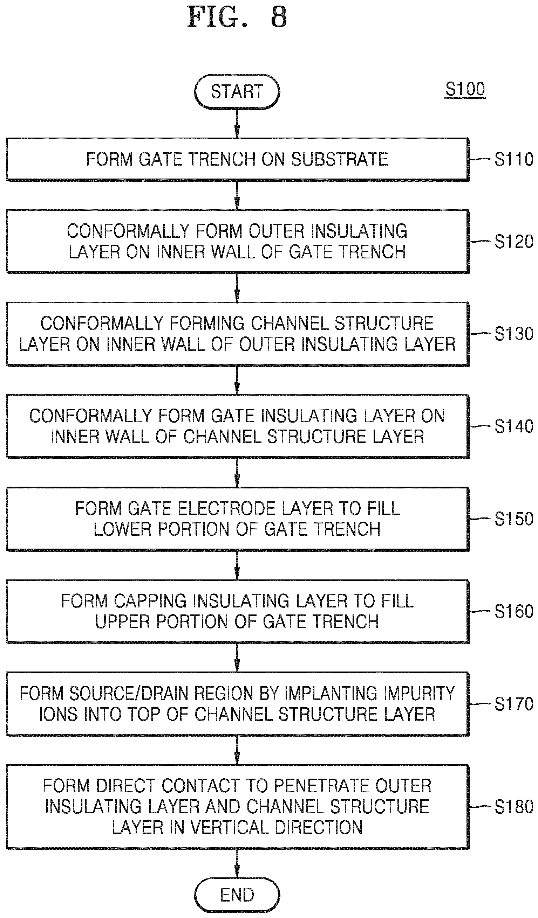

FIG. 8 is a flowchart illustrating a method of manufacturing an integrated circuit device, according to an example embodiment of the inventive concepts.

Referring to FIG. 8, a method 5100 of manufacturing an integrated circuit device may include a process sequence of first to eighth operations S110 to S180.

Example embodiments may be implemented differently, where a particular process order may be performed differently from the described order. For example, two processes described in succession may be performed substantially simultaneously, or may be performed in an order opposite to the described order.

The method 5100 of manufacturing an integrated circuit device, according an example embodiment of the inventive concepts, may include a first operation of forming a gate trench in a substrate in S110, a second operation of conformally forming an outer insulating layer on the inner wall of the gate trench in S120, a third operation of conformally forming a channel structure layer on the inner wall of the outer insulating layer in S130, a fourth operation of conformally forming a gate insulating layer on the inner wall of the channel structure layer in S140, a fifth operation of forming a gate electrode layer to fill the lower portion of the gate trench in S150, a sixth operation of forming a capping insulating layer to fill the upper portion of the gate trench in S160, a seventh operation of forming a source/drain region by implanting impurity ions into the top of the channel structure layer in S170, and an eighth operation of forming a direct contact to penetrate (for example, partially penetrate) the outer insulating layer and the channel structure layer in a vertical direction in S180.

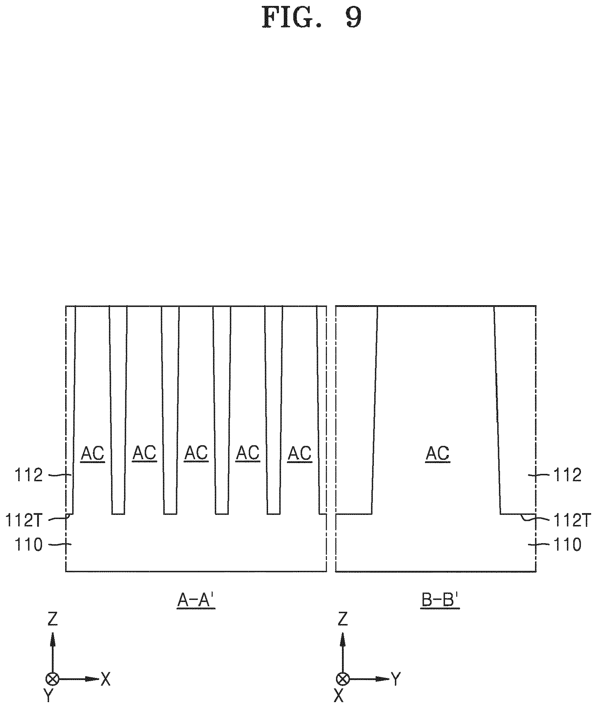

The technical characteristics of each of the first to eighth operations S110 to S180 are described in detail with reference to FIGS. 9 to 25 below.

FIGS. 9 to 25 are cross-sectional views showing a manufacturing method of an integrated circuit device, according to an example embodiment of the inventive concepts according to a process sequence.

Referring to FIG. 9, a plurality of active areas AC may be defined on the substrate 110 by forming a plurality of element isolation trenches 112T in the substrate 110 and forming an element isolation film 112 in the element isolation trench 112T. The plurality of active areas AC may be arranged to have long axes in an oblique direction with respect to the first horizontal direction (X direction) and the second horizontal direction (Y direction), respectively.

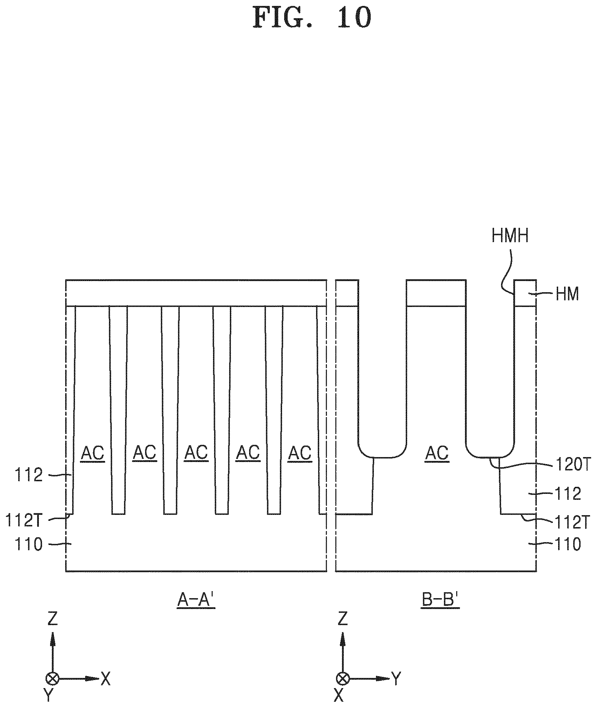

Referring to FIG. 10, a hard mask layer HM may be formed on the substrate 110. The hard mask layer HM may include an opening HMH extending in the first horizontal direction (X direction). Next, a gate trench 120T may be formed in the substrate 110 by using the hard mask layer HM as an etch mask.

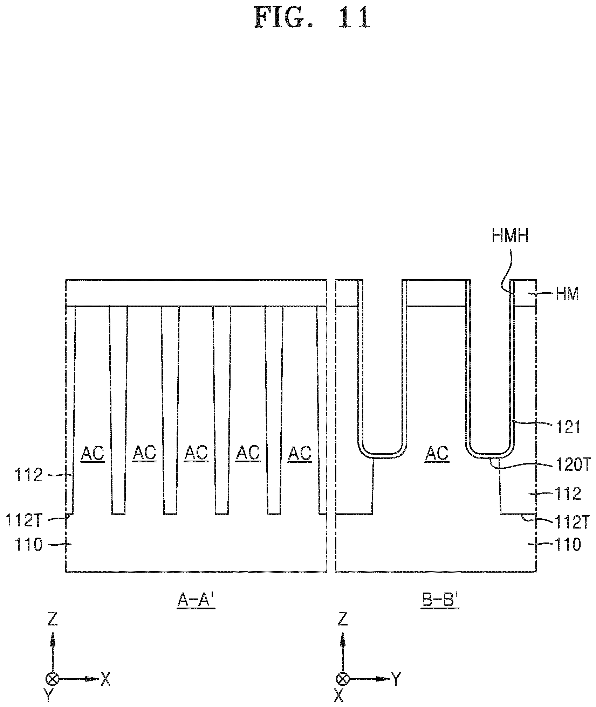

Referring to FIG. 11, the outer insulating layer 121 may be conformally formed on the inner wall of the gate trench 120T and the inner wall of the hard mask layer HM. In some example embodiments, the outer insulating layer 121 may include silicon oxide, silicon nitride, silicon oxynitride, or a combination thereof. In some example embodiments, the outer insulating layer 121 may be formed by a CVD process or an ALD process. In other example embodiments, the outer insulating layer 121 may be formed by an epitaxial growth process.

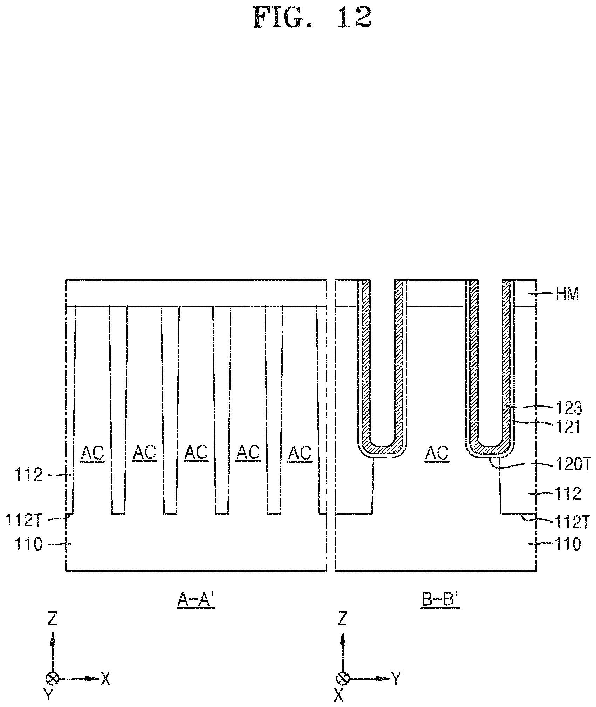

Referring to FIG. 12, a channel structure layer 123 may be conformally formed on the inner wall of the outer insulating layer 121. In some example embodiments, the channel structure layer 123 may be any one selected from polysilicon, crystalline silicon, crystalline IGZO, and amorphous IGZO, but example embodiments are not limited thereto. For example, the channel structure layer 123 may be formed through a CVD process or an ALD process.

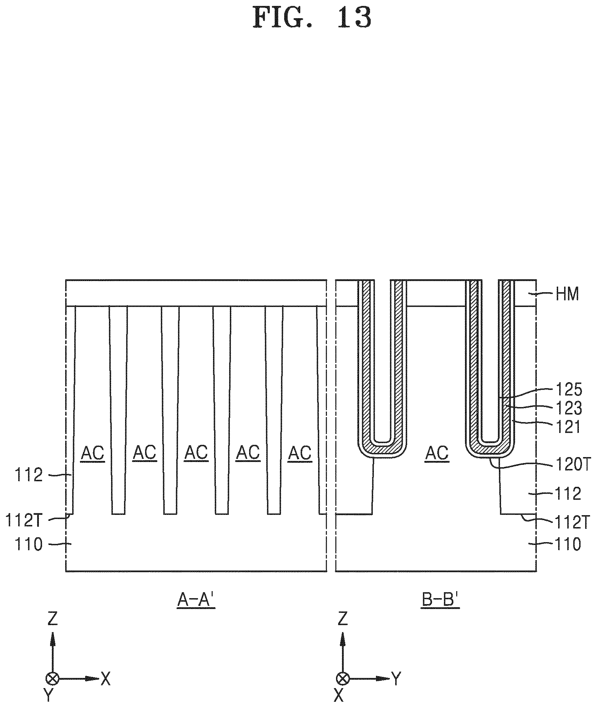

Referring to FIG. 13, a gate insulating layer 125 may be conformally formed on the inner wall of the channel structure layer 123. In some embodiment, the gate insulating layer 125 may include silicon oxide, silicon nitride, silicon oxynitride, ONO, or a high-k material having a higher dielectric constant than silicon oxide, but example embodiments are not limited thereto.

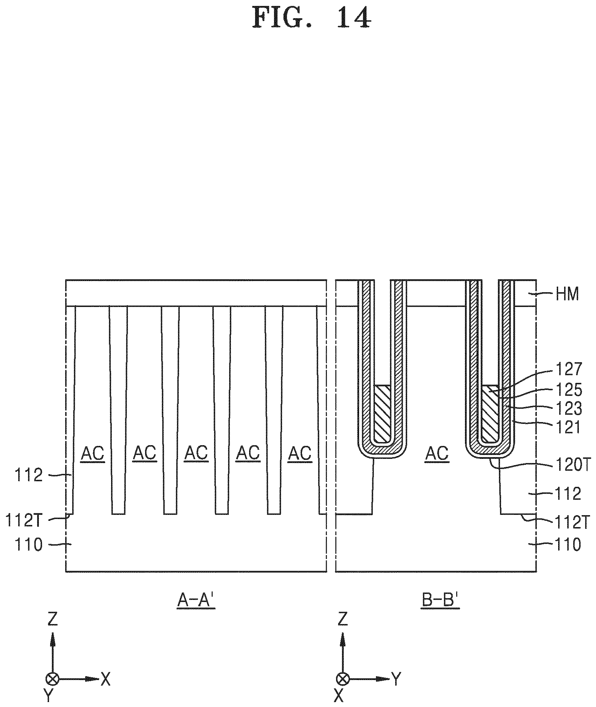

Referring to FIG. 14, a gate metal layer (not shown) may be formed in the plurality of gate trenches 120T. The gate metal layer may include Ti, TiN, Ta, TaN, W, WN, TiSiN, WSiN, doped polysilicon, or combinations thereof, but example embodiments are not limited thereto. Next, the gate electrode layer 127 may be formed by performing an etch-back process on the gate metal layer.

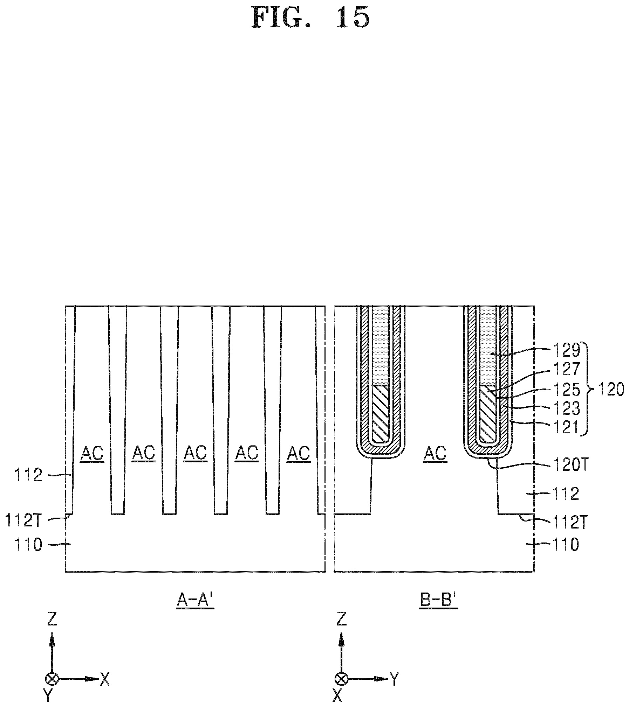

Referring to FIG. 15, a gate insulating layer (not shown) may be formed inside the gate trench 120T, and a planarization process may be performed on the upper side of the gate insulating layer so that the upper surface of the substrate 110 is exposed to form the capping insulating layer 129. In the planarization process, the hard mask layer HM may be removed also. Next, a plurality of source/drain regions (not shown) may be formed on the plurality of channel structure layers 123 by implanting impurity ions into portions on both sides of the upper portion of the plurality of channel structure layers 123.

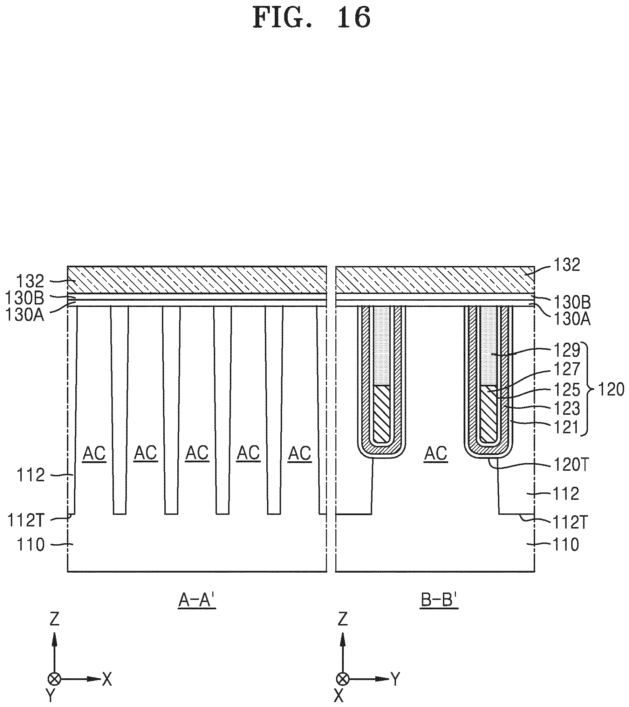

Referring to FIG. 16, a first lower insulating layer 130A and a second lower insulating layer 130B may be formed on the substrate 110. Next, a lower conductive layer 132 may be formed on the second lower insulating layer 130B. In some example embodiments, the lower conductive layer 132 may include Si, Ge, W, WN, Co, Ni, Al, Mo, Ru, Ti, TiN, Ta, TaN, Cu, or a combination thereof. For example, the lower conductive layer 132 may include doped polysilicon.

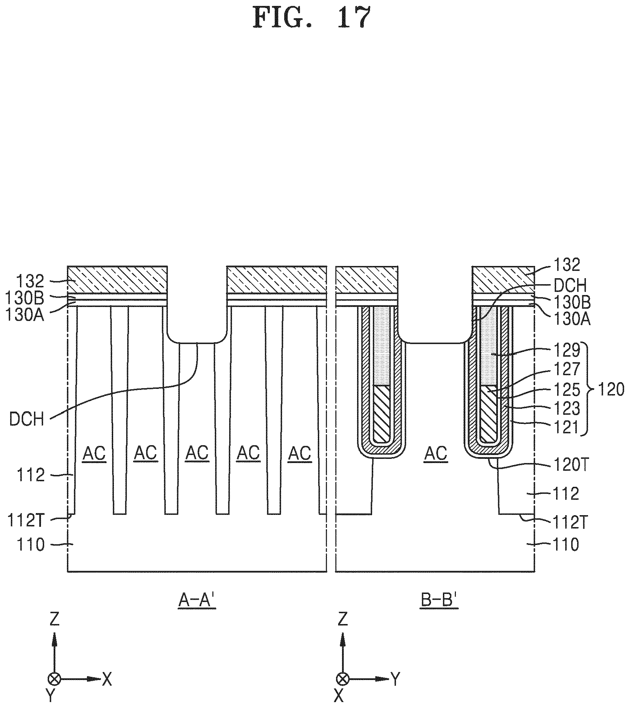

Referring to FIG. 17, a mask pattern (not shown) may be formed on the lower conductive layer 132. Next, the lower conductive layer 132 exposed through the opening (not shown) of the mask pattern is etched, and as a result, a portion of the substrate 110 and a portion of the element isolation film 112 exposed are etched, so that a direct contact hole DCH exposing the active area AC of the substrate 110 may be formed. The direct contact hole DCH may be formed to penetrate (for example, partially penetrate) the active area AC, the outer insulating layer 121, and the channel structure layer 123 in a vertical direction (Z direction). Here, the inner wall of the direct contact hole DCH and the outer wall of the gate insulating layer 125 may face each other and be spaced apart from each other with the channel structure layer 123 therebetween.

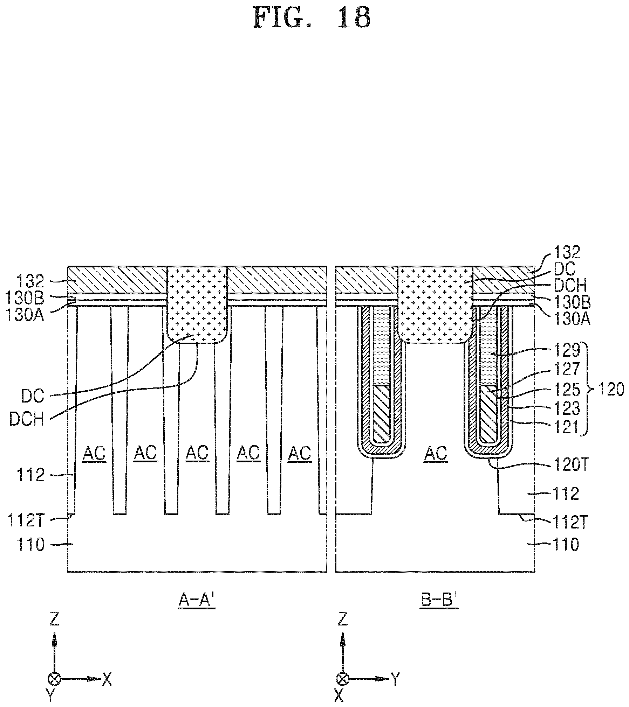

Referring to FIG. 18, the mask pattern may be removed and a direct contact DC may be formed in the direct contact hole DCH. As a process of forming a direct contact DC, a conductive layer having a thickness sufficient to fill the direct contact hole DCH may be formed inside the direct contact hole DCH and on top of the lower conductive layer 132, and the conductive layer may be etched back so that the conductive layer remains only within the direct contact hole DCH. The conductive layer may include doped polysilicon.

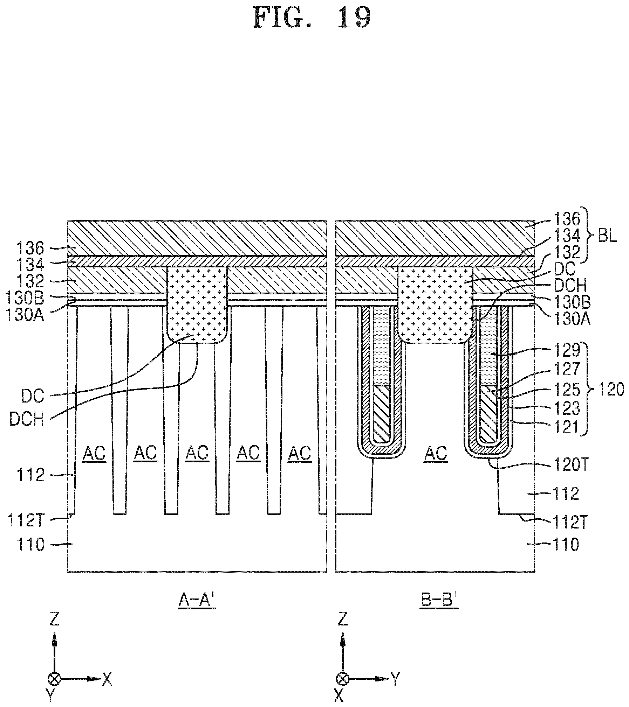

Referring to FIG. 19, a middle conductive layer 134 and an upper conductive layer 136 may be sequentially formed on the lower conductive layer 132 and the direct contact DC. The middle conductive layer 134 and the upper conductive layer 136 may each include TiN, TiSiN, W, tungsten silicide, or a combination thereof, but example embodiments are not limited thereto. In some example embodiments, the middle conductive layer 134 may be made of TiN, TiSiN, or a combination thereof, and the upper conductive layer 136 may include tungsten (W).

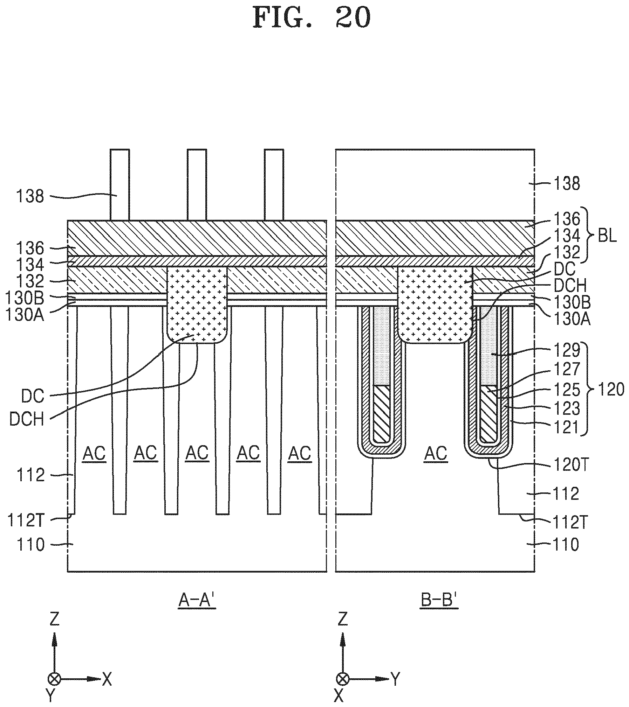

Referring to FIG. 20, an insulating layer (not shown) is formed on the upper conductive layer 136, and the insulating layer is patterned to form a plurality of bit line capping layers 138 extending in a second horizontal direction (Y direction). The plurality of bit line capping layers 138 may include silicon nitride.

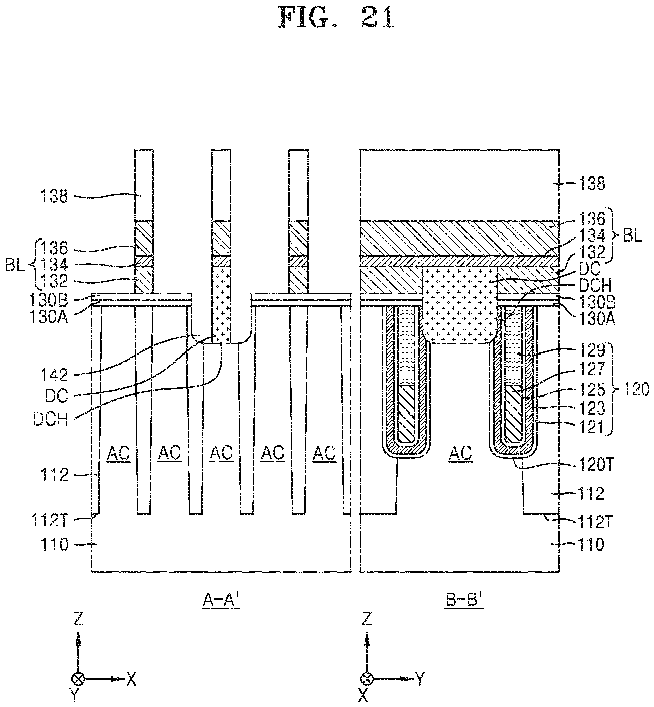

Referring to FIG. 21, the upper conductive layer 136, the middle conductive layer 134, and the lower conductive layer 132 may be patterned using the plurality of bit line capping layers 138 as an etch mask. As a result, a plurality of bit lines BL including the lower conductive layer 132, the middle conductive layer 134, and the upper conductive layer 136 are formed. In the process of forming the plurality of bit lines BL, a portion of the sidewall of the direct contact DC may be removed and a portion of the direct contact hole DCH may be exposed.

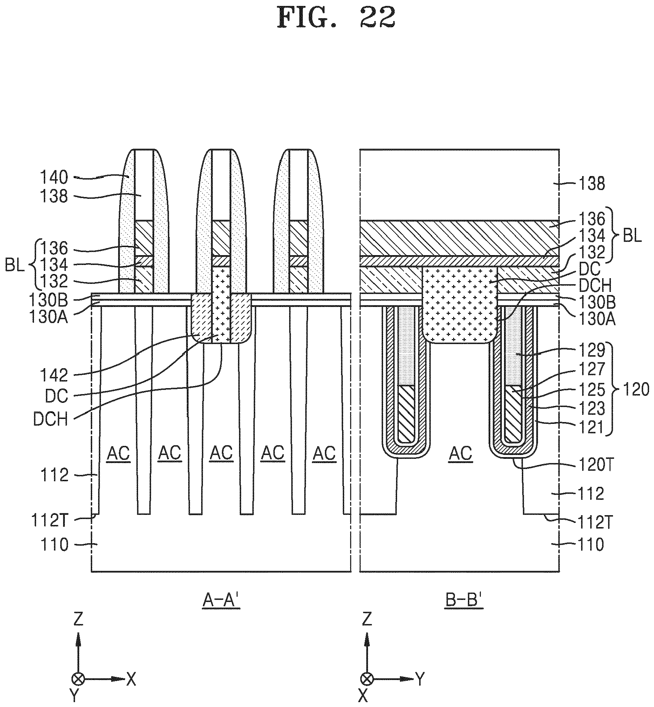

Referring to FIG. 22, direct contact spacers 142 may be formed on sidewalls of direct contacts DC, and bit line spacers 140 may be formed on sidewalls of a plurality of bit lines BL. In some example embodiments, after conformally forming an insulating layer (not shown) on the sidewalls and upper surfaces of the plurality of bit lines BL, by performing an anisotropic etching process on the insulating layer, bit line spacers 140 may be left on the sidewalls of the plurality of bit lines BL and direct contact spacers 142 may be left on the sidewalls of the direct contacts DC. In some example embodiments, the bit line spacer 140 and the direct contact spacer 142 may be formed using silicon nitride.

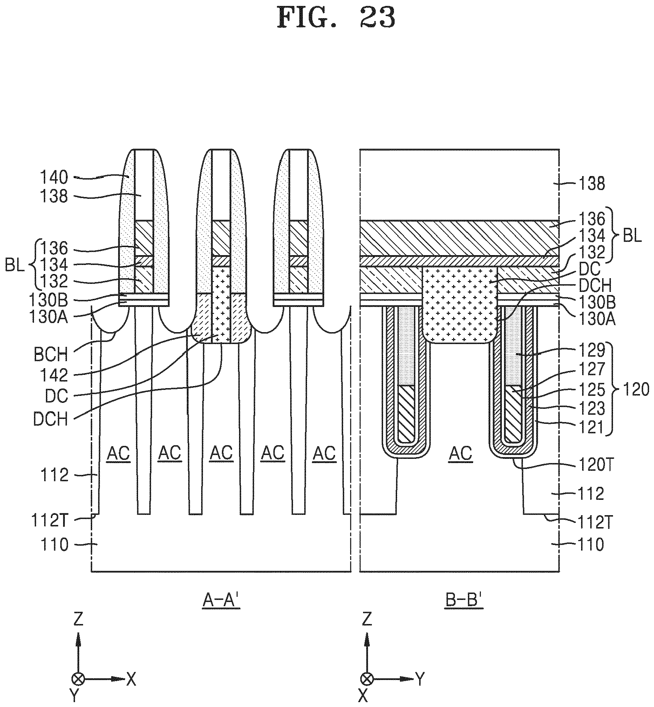

Referring to FIG. 23, a plurality of insulation fences (not shown) may be formed between each of the plurality of bit lines BL. As a result, by removing portions of the second lower insulating layer 130B, the first lower insulating layer 130A, and the substrate 110, which are exposed through the space between two adjacent insulation fences among the plurality of insulation fences and between the two bit lines BL, a plurality of buried contact holes BCH exposing the active area AC of the substrate 110 are formed between each of the plurality of bit lines BL.

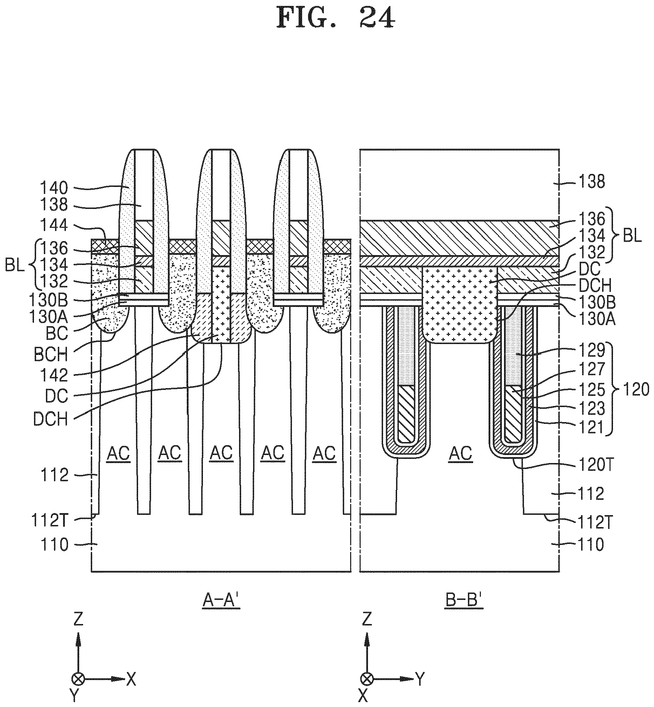

Referring to FIG. 24, while filling a plurality of buried contact holes BCH between each of a plurality of bit lines BL, a plurality of buried contacts BC filling spaces between each of the plurality of bit lines BL are formed. Next, a metal silicide film 144 may be formed on the plurality of buried contacts BC.

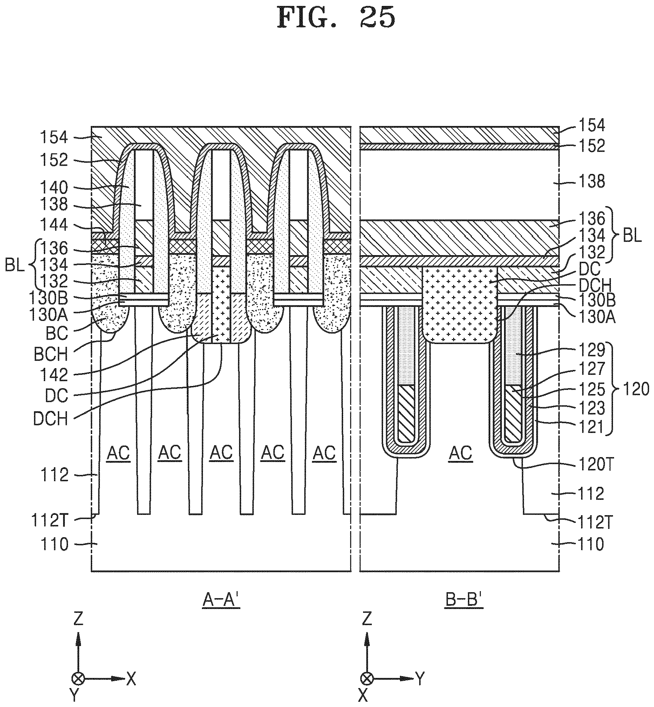

Referring to FIG. 25, a conductive barrier film 152 and a conductive landing pad layer 154 covering an exposed surface of the substrate 110 may be formed. The conductive barrier film 152 may include Ti, TiN, or a combination thereof. The conductive landing pad layer 154 may include metal, metal nitride, doped polysilicon, or a combination thereof, but example embodiments are not limited thereto. For example, the conductive landing pad layer 154 may include W.

Referring back to FIG. 2, a plurality of landing pads LP may be formed by patterning the conductive landing pad layer 154 and the conductive barrier film 152. In a plan view, the plurality of landing pads LP may have a plurality of island-shaped pattern shapes. The plurality of landing pads LP may be formed to vertically overlap portions of the plurality of bit lines BL on the metal silicide film 144. As the plurality of landing pads LP are formed in an island pattern shape, an insulating space 156S surrounding the plurality of landing pads LP may be formed. An insulating pattern 156 may be formed on an inner wall of the insulating space 156S by using an insulating material. The insulating pattern 156 may be formed by spin coating, a chemical vapor deposition (CVD) process, a flowable CVD (FCVD) process, or the like. Next, capacitors (not shown) may be formed on the plurality of landing pads LP.

According to this example manufacturing method, the integrated circuit device 100 is completed. By forming an independent channel structure layer 123 made of a semiconductor material on each of the buried word lines WL, the integrated circuit device 100 according to an example embodiment of the inventive concept may have high integration, high reliability, and excellent electrical performance.

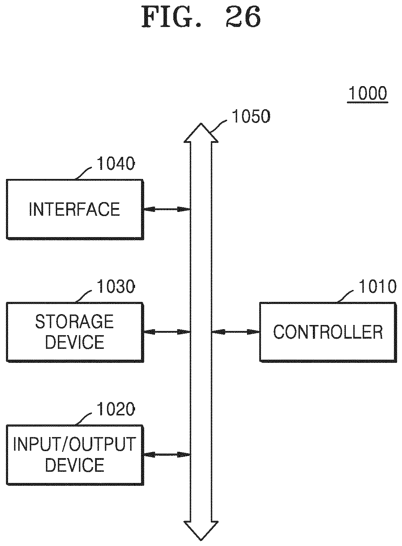

FIG. 26 is a block diagram illustrating a system including an integrated circuit device according to an example embodiment of the inventive concepts.

Referring to FIG. 26, a system 1000 includes a controller 1010, an input/output device 1020, a storage device 1030, an interface 1040, and a bus 1050.

The system 1000 may be a mobile system or a system that transmits or receives information. In some example embodiments, the mobile system may be a portable computer, web tablet, mobile phone, digital music player, or memory card.

The controller 1010 is for controlling an executable program in the system 1000, and may include a microprocessor, a digital signal processor, a microcontroller, or a similar device.

The input/output device 1020 may be used to input or output data of the system 1000. The system 1000 may be connected to an external device, for example, a personal computer or a network, using the input/output device 1020, and may exchange data with the external device. The input/output device 1020 may be, for example, a touch screen, a touch pad, a keyboard, or a display.

The storage device 1030 may store data for the operation of the controller 1010 or store data processed by the controller 1010. The storage device 1030 may include at least one of the integrated circuit devices 100, 200, 300, 400, and 500 according to the technical idea of the inventive concept described above.

The interface 1040 may be a data transmission path between the system 1000 and an external device. The controller 1010, the input/output device 1020, the storage device 1030, and the interface 1040 may communicate with each other via the bus 1050.

It will be understood that elements and/or properties thereof described herein as being "substantially" the same and/or identical encompasses elements and/or properties thereof that have a relative difference in magnitude that is equal to or less than 10%. Further, regardless of whether elements and/or properties thereof are modified as "substantially," it will be understood that these elements and/or properties thereof should be construed as including a manufacturing or operational tolerance (e.g., ±10%) around the stated elements and/or properties thereof.

One or more of the elements disclosed above may include or be implemented in one or more processing circuitries such as hardware including logic circuits; a hardware/software combination such as a processor executing software; or a combination thereof. For example, the processing circuitries more specifically may include, but is not limited to, a central processing unit (CPU), an arithmetic logic unit (ALU), a digital signal processor, a microcomputer, a field programmable gate array (FGPA), a System-on-Chip (SoC), a programmable logic unit, a microprocessor, application-specific integrated circuit (ASIC), etc.

While the inventive concepts have been particularly shown and described with reference to some example embodiments thereof, it will be understood that various changes in form and details may be made therein without departing from the scope of the inventive concepts.

## Claims

1. An integrated circuit device comprising:
a first substrate including an element isolation film defining an active area; and
a first gate structure buried in the active area of the first substrate,
the first gate structure including
a first gate trench,
a first outer insulating layer formed conformally along an inner wall of the first gate trench,
a first channel structure layer formed conformally on the first outer insulating layer,
a first gate insulating layer formed conformally on the first channel structure layer,
a first gate electrode layer filling a lower area of the first gate trench, and
a first capping insulating layer on the first gate electrode layer, the first capping insulating layer filling an upper area of the first gate trench.

2. The integrated circuit device of claim 1, wherein the first channel structure layer comprises at least one of polysilicon, crystalline silicon, crystalline Indium Gallium Zinc Oxide, IGZO, and amorphous IGZO.

3. The integrated circuit device of claim 1 or 2, wherein
an upper area of the first channel structure layer is highly doped and is configured to operate as a source/drain region,
a lower area of the first channel structure layer is doped with a lower concentration than the upper area of the first channel structure layer, and the lower area of the first channel structure layer is configured to operate as a channel region,
the first gate electrode layer is electrically connected to a word line,
a first end of the first channel structure layer is electrically connected to a bit line, and
a second end of the first channel structure layer is electrically connected to a capacitor.

4. The integrated circuit device of claim 3,
further comprising a contact plug connected to the bit line and partially penetrating the first substrate and the first gate structure,
wherein a portion of the contact plug is in contact with the source/drain region of the first channel structure layer.

5. The integrated circuit device of claim 4, wherein a contact insulating layer is between the contact plug and the first substrate.

6. The integrated circuit device of claim 5, wherein the contact insulating layer is continuously connected to the first outer insulating layer.

7. The integrated circuit device of any one of claims 4 to 6, wherein a sidewall of the contact plug is spaced apart from a sidewall of the first gate insulating layer.

8. The integrated circuit device of any one of claims 4 to 6, wherein a sidewall of the contact plug is in contact with a sidewall of the first gate insulating layer.

9. The integrated circuit device of any one of claims 1 to 8, wherein the first channel structure layer is isolated from the first substrate by the first outer insulating layer.

10. The integrated circuit device of claim 9, wherein the first channel structure layer is configured to facilitate movement of electrons in the first gate structure.

11. The integrated circuit device according to any one of claims 1 to 10, further comprising:
a second substrate;
a peripheral circuit structure on the second substrate, the peripheral circuit structure including a peripheral circuit;
a memory cell structure on the peripheral circuit structure, the memory cell structure including the first substrate and the element isolation film defining the active area; and
a plurality of gate structures buried in the active area of the memory cell structure,
each of the plurality of gate structures including
a gate trench,
an outer insulating layer formed conformally along an inner wall of the gate trench,
a channel structure layer formed conformally on the outer insulating layer,
a gate insulating layer formed conformally on the channel structure layer,
a gate electrode layer filling a lower area of the gate trench, and
a capping insulating layer on the gate electrode layer, the capping insulating layer filling an upper area of the gate trench, and at least a portion of the plurality of gate structures electrically connected to the peripheral circuit through a vertical via.

12. The integrated circuit device of claim 11, wherein
the channel structure layer comprises at least one of polysilicon, crystalline silicon, crystalline Indium Gallium Zinc Oxide, IGZO, and amorphous IGZO,
a body portion of the memory cell structure comprises an insulating material including silicon,
the gate electrode layer is electrically connected to a word line,
a first end of the channel structure layer is electrically connected to a bit line, and
a second end of the channel structure layer is electrically connected to a capacitor.

13. The integrated circuit device of claim 11 or 12, further comprising a plurality of contact plugs partially penetrating a body portion of the memory cell structure and the plurality of gate structures,
wherein each of the plurality of contact plugs is electrically connected to the channel structure layer, and
wherein at least a portion of the plurality of contact plugs are electrically connected to the vertical via.

14. The integrated circuit device of claim 13, wherein a contact insulating layer is between the plurality of contact plugs and the body portion of the memory cell structure.

15. The integrated circuit device of claim 13 or 14, wherein a sidewall of at least one of the plurality of contact plugs is spaced apart from a sidewall of the gate insulating layer.
